# EUROPÄISCHE PATENTSCHRIFT

(11) **EP 3 321 944 B1**
(45) Veröffentlichungstag und Bekanntmachung des Hinweises auf die Patenterteilung: **06.04.2022**
(21) Anmeldenummer: 17001864.2
(22) Anmeldetag: 17.09.2014
(51) Int. Cl.: H01F 27/02, F41H 5/24

(54) **BESCHUSSBESTÄNDIGE ELEKTRISCHE ANLAGE**
BOMBARDMENT-RESISTANT ELECTRICAL INSTALLATION
INSTALLATION ÉLECTRIQUE RÉSISTANTE AU BOMBARDEMENT

(43) Veröffentlichungstag der Anmeldung: 16.05.2018
(62) Teilanmeldung aus: 14780755.6
(73) Patentinhaber: Siemens Energy Global GmbH & Co. KG, 81739 München (DE)
(72) Erfinder: Leber, Gerald, 8211 Großpesendorf (AT)

(56) Entgegenhaltungen:
- DE-A1- 3 633 349
- DE-A1- 3 729 048
- DE-A1- 10 002 630
- DE-U1- 8 609 852

## Beschreibung

### Technisches Gebiet

Die Erfindung betrifft allgemein das technische Gebiet elektrischer Anlagen, insbesondere elektrische Transformatoren, Phasenschieber und Drosseln großer Nennleistung, wie Sie üblicherweise in Energieverteilungsnetzen eingesetzt werden.

### Stand der Technik

Elektrische Anlagen, wie Transformatoren, Drosseln oder Schaltvorrichtungen, stellen in einem Energieverteilungsnetz Knotenpunkte dar, die in Krisenzeiten potentielle Angriffsziele für zerstörerische Anschläge von außen sein können. Solche Anschläge sind beispielsweise Angriffe aus umgebendem Terrain durch Beschuss mit Handfeuerwaffen, durch Sprengsatz, der in der Nähe der elektrischen Anlage detoniert, oder auch durch Granat- und Bombensplitter. Besonders verwundbar sind dabei die Seitenwände eines mit einem Fluid gefüllten Kessel. Wenn ein Beschuss auf diese Seitenwände auftrifft, kann - je nach Intensität der Geschosseinwirkung - ein Leck auftreten. Aber auch dann, wenn der Kessel dicht bleibt, kann sich in einem flüssigkeitsgefüllten Kessel eine Druckwelle fortpflanzen, die Sicherheitseinrichtungen dazu veranlasst, die Anlage abzuschalten. In beiden Fällen kann die Energieversorgung durch den Angriff beeinträchtigt sein.

Die DE 100 02 630 A1 betrifft eine Umspannstation mit einem Gusskörper aus Beton, der unter anderem einen Raum für einen Mittelspannungstransformator aufweist. Dieser aus Beton bestehende Baukörper ist mit einer Armierung aus einem Werkstoff mit hoher Zugfestigkeit ausgerüstet.

Die DE 37 29 048 A1 betrifft einen Transformator mit einem Transformatorkessel, dessen Seitenwände an der Innenseite durch Schutzplatten verstärkt sind. Diese Schutzplatten bestehen aus einem Sonderstahl und dienen zum Abfangen von Granat- oder Bombensplittern.

Die DE 36 33 349 A1 betrifft ein durchschusshemmendes Wandlungselement zum Schutz von Industrieanlagen. Dieses Wandlungselement verfügt über eine ebene Stahlblechaußenwand, die trotz ihres einfachen Aufbaus einen hohen Widerstand gegenüber Geschossen aufweist. Ferner ist eine Stahlblechinnenwand vorgesehen, wobei Stahlblechzwischenwände ebenfalls offenbart sind.

Weiterer Stand der Technik ist in der DE 86 09 852 U1 beschrieben.

Aus der DE 37 29 048 A1 ist beispielsweise ein Objektschutz für einen Transformator mit großer Nennleistung bekannt, bei dem zum Schutz vor äußeren mechanischen Einwirkungen die Seitenwände des Transformatorkessels innenseitig mit Schutzplatten armiert sind. Die Schutzplatten sind innenseitig an die Seitenwände geschweißt und bestehen aus einem Sonderstahl zum Abfangen von Splitter und Geschossen. Ein Nachteil ist, dass im Bereich der Schweißnaht die schützende Armierung geschwächt ist. Ein weiterer Nachteil ist, dass im Falle eines Beschlusses sich im flüssigkeitsgefüllten Kessel Druckwellen fortpflanzen, was dazu führen kann, dass Sicherheitseinrichtungen den Transformator abschalten. Dann ist die Energieversorgung zumindest zeitweise unterbrochen.

### Darstellung der Erfindung

Es ist eine Aufgabe der vorliegenden Erfindung eine elektrische Anlage in einem Energieverteilungsnetz, insbesondere einen Transformator oder eine Drossel so zu schützen, dass auch im Falle eines Angriffs mit Handfeuerwaffen oder mit einem Sprengsatz die Energieversorgung nicht beeinträchtigt wird. Gelöst wird diese Aufgabe durch eine elektrische Anlage mit den Merkmalen des Anspruchs 1.

Die vorrichtungsbezogene Aufgabe wird gelöst durch eine elektrische Anlage, insbesondere einem Transformator, einem Phasenschieber oder eine Drossel, mit einem fluidgefüllten Kessel, der Seitenwände aufweist, wobei zum Schutz vor Beschuss- und/oder Splittereinwirkung
- die Seitenwände durchschusshemmend aus einem Werkstoff, der eine Zugefestigkeit Rₘ aufweist, die größer als 1000 MPa ist, gebildet sind.

Die Beschussbeständigkeit kann also erreicht werden, indem zumindest die Seitenwände des Kessels, z.B. aus einem Stahl mit einer Zugefestigkeit Rₘ von größer als 1000 MPa gefertigt sind.

Die Zugfestigkeit von Materialien ist in DIN EN ISO 6892-1 definiert.

Einem Grundgedanken der Erfindung nach wird also der Objektschutz durch eine durchschusshemmende Ausführung des Kessels erreicht. Das Fluid im Kessel kann eine Kühl- oder Isolationsflüssigkeit sein, z.B. Trafo-Öl, oder ein Gas in einer Schalteranlage.

Unter dem Begriff beschussbeständig ist die Beständigkeit eines Materials oder einer Konstruktion zu verstehen, einer Durchdringung eines Geschosses unter definierten Bedingungen stand zu halten. Eine Definition der Geschossbeständigkeit ist beispielsweise in der amerikanischen Norm UL 742 (Ratings of Bullet Resistant materials) durch Level 1 bis Level 10 definiert. Korrespondierend hierzu sind in der allgemeinen Prüfungsrichtlinie 2006 der Vereinigung der Prüfstellen für angriffhemmende Materialien und Konstruktionen (VPMA APR 2006) Prüfstufen zwischen 1 und 14 definiert. Die Prüfstufe 1 beginnt mit einem Kaliber .22 Ir, einer Geschossmasse von 2,6 g und einer Geschossenergie von etwa 160 J (Joule). Die Prüfstufe 14 umfasst ein Kaliber 14,5 x 114, eine Geschossmasse von etwa 64 g und eine Geschossenergie von 26308 J (Joule). In der europäischen Norm DIN EN 1063 sind korrespondierende Bereiche zwischen BR1 und BR 7 definiert. Diese ballistisch definierte beschusshemmende Wirkung gegenüber einer Faustfeuerwaffe bzw. Langwaffe gilt im Sinne der Erfindung analog auch für die Splitterwirkung eines in der Nähe der Anlage detonierenden Sprengkörpers. Mit anderen Worten, die erfindungsgemäße Schutzmaßnahme umfasst zumindest einen in den oben angegebenen Normen angegebenen Wirkungsbereich. Mit anderen Worten, eine Beschusseinwirkung in einem solchen Bereich führt nicht dazu, dass im Kessel der elektrischen Anlage ein Leck auftritt. Eine Schutzmaßnahme innerhalb dieses Wirkungsbereichs (Level 1 bis 10, bzw. Prüfstufe 1-14) lässt sich mit vertretbarem Aufwand realisieren. Prinzipiell kann eine elektrische Anlage auch über diesen Wirkungsbereich hinausgehend gegen Beschuss geschützt werden.

Erfindungsgemäß wird für die Schutzmaßnahme ein Werkstoff verwendet, der eine Zugfestigkeit Rm aufweist, die größer als 1000 MPa (Mega Pascal)ist. Eine hohe Zugfestigkeit macht den Werkstoff für eine Armierung oder Panzerung besonders geeignet. Ein solcher Werkstoff mit hoher Zugfestigkeit kann ein metallischer oder auch ein nicht metallischer Werkstoff sein, zum Beispiel ein Polymerwerkstoff, ein mit Carbonfaser verstärkter Kunststoff, ein Werkstoff auf der Basis von Polyethylen, oder Aramidfasern. Bekannte Markennamen für Aramidfasern sind beispielsweise Nomex^{®} und Kevlar^{®} von DuPont. Dabei können die Kunststofffasern unterschiedlich miteinander verwoben und verwirkt sein. Auch eine Sandwich-Konstruktion aus einem Verbund bestehend aus Metall und Nichtmetall (einem Kunststoff, einem Kohlenstofffasern-Vlies oder ähnlichen) ist als Werkstoff für die durchschusshemmende Armierung prinzipiell geeignet. Der Vorteil eines Polymers liegt im vergleichsweise geringeren Gewicht, demgegenüber stehen höhere Kosten.

### Kurzbeschreibung der Zeichnung

Im nachfolgenden Teil der Beschreibung wird auf Zeichnungen Bezug genommen, die einen Transformator zeigen, der auf Grund der durchgeführten Einschränkungen nicht mehr Gegenstand der vorliegenden Erfindung ist.

Es zeigen:
- Figur 1: eine perspektivische Ansicht eines Transformators, dessen Kessel-Seitenwände von einer durchschusshemmenden Armierung umhüllt ist;
- Figur 2: der Transformator gemäß Figur 1, in einem Blickwinkel von schräg unten auf den vorderseitig angebrachten Radiator;
- Figur 3: den Transformator gemäß Figur 1, in einer Draufsicht;
- Figur 4: eine Ausführung der Erfindung, bei der die Armierung durch einzelne vertikal angeordnete Paneele gebildet ist, gemäß Detail X der Figur 3;
- Figur 5: eine beispielhafte Ausführung einer Befestigung der Paneele am Kessel.

### Ausführung der Erfindung

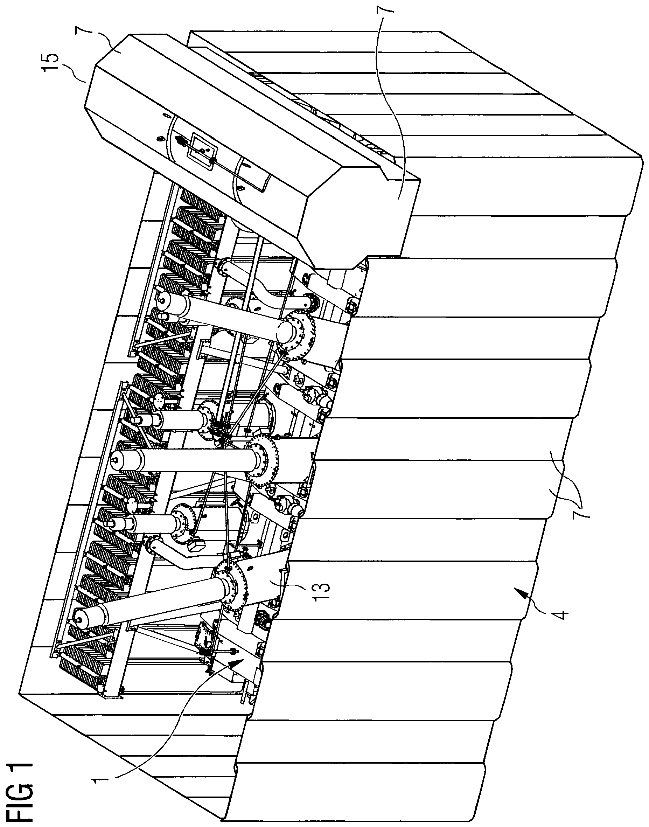

Die Figur 1 zeigt in einer perspektivischen Ansicht eine beschussbeständige elektrische Anlage, dargestellt am Beispiel eines Leistungstransformators 1. Der Leistungstransformator 1 steht dabei auf einem nicht näher dargestellten Fundament. Gemäß dem dargestellten Ausführungsbeispiel umhüllt die durchschusshemmende Armierung bzw. Panzerung 4 die Seitenwände des Leistungstransformators 1 und ragt bis in den Bodenbereich. Die Panzerung 4 ist hinsichtlich ihrer Beschaffenheit und ihrer Abmessung so konstruiert, dass sie einer vom umgebenden Terrain ausgehenden Beschuss- oder Splitter-Bedrohung standhält, so dass alle Anlagenteile geschützt sind. Im dargestellten Ausführungsbeispiel der Figur 1 besteht diese Armierung bzw. Panzerung 4 aus einzelnen Platten oder Paneelen 7, die eine vertikale Schutzwand bilden. Diese aneinandergereihten Platten 7 umschließen die Anlage 1 ringsum. Sie bilden eine vor Beschuss und Splittereinwirkung schützende Schutzhülle. Gefertigt sind die einzelnen Paneele 7 aus einem Stahlblech, dessen Zugfestigkeit Rₘ > 1000 Mega Pascal ist. Die Blechdicke richtet sich je nach angestrebtem Rating (UL 752) bzw. je nach Prüfstufe (VPAM APR 2006). Die Länge der einzelnen Paneele 7 ist dabei so bemessen, dass eine aus dem umgebenden Terrain einwirkende Beschuss- oder Splittereinwirkung weder den Transformator 1, noch den auf dem Kesseldeckel befindlichen Anlagenteilen Schaden zufügen kann. Wie in Figur 1 dargestellt, überragen daher die einzelnen Paneele 7 mit ihrem oberen Ende die auf dem Kesseldeckel angeordneten Anlagenkomponenten, wie Unterteile von Hochspannungs-Durchführungen und Dome 10 oder andere Anlagenteile des Leistungstransformators 1.

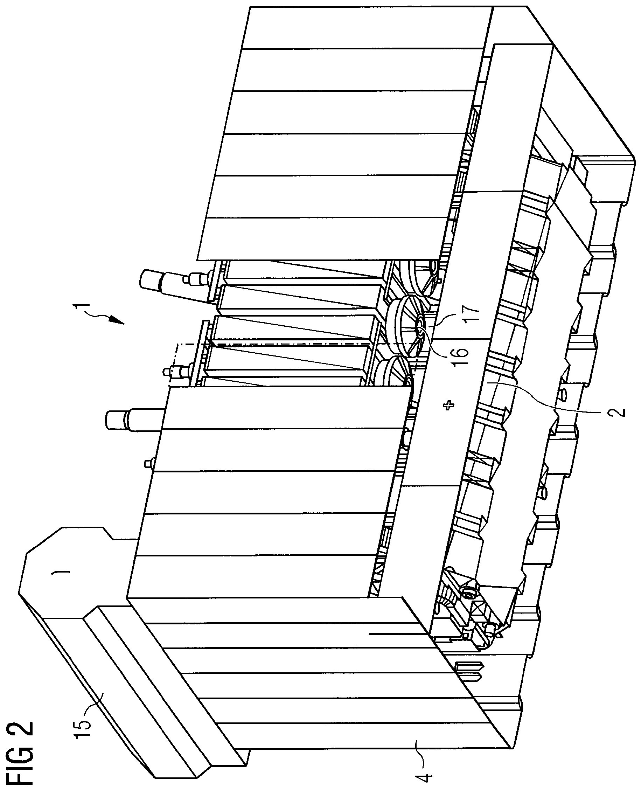

Figur 2 zeigt den in Figur 1 dargestellten Leistungstransformator 1 ebenfalls in einer perspektivischen Ansicht, diesmal aber mit Blickrichtung von hinten und schräg unten. Der Leistungstransformator 1 besitzt zur Abfuhr der Betriebswärme an einer Längs-Seitenwand einen Radiator 16. Der Blick ist in Figur 2 von schräg unten auf diesen Radiator 16 gerichtet. Der Radiator 16 ist außenseitig ebenfalls gepanzert und vor zerstörerischer Seiteneinwirkung geschützt. Zum Zweck der Kühlung ist zwar ein vertikaler Kühlkanal im Bereich des Radiator 16 offen gelassen, dieser ist aber ebenfalls außenseitig durch Paneele 7 kugel- bzw. splittersicher abgeschirmt.

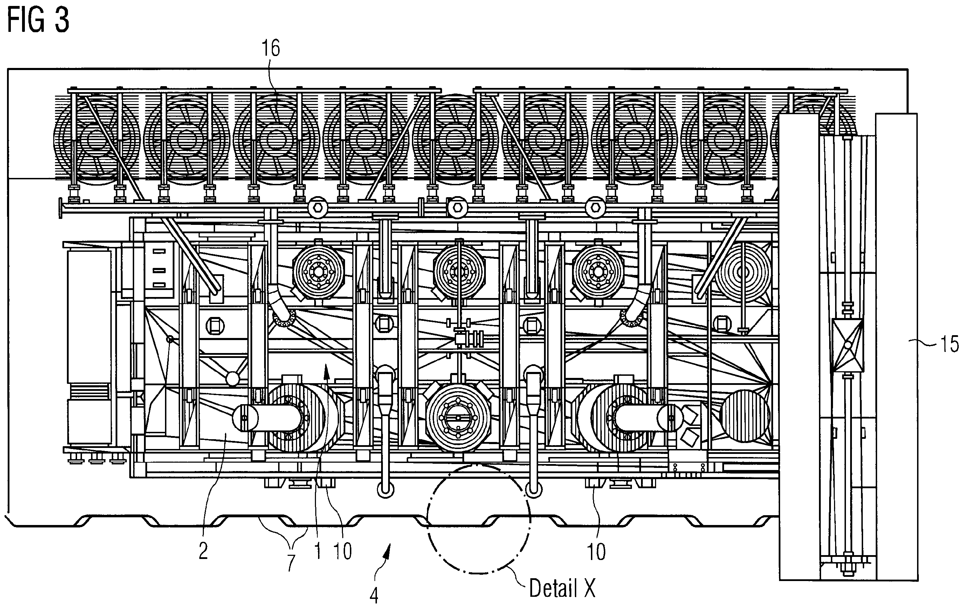

Figur 3 zeigt den Leistungstransformator 1 gemäß Figur 1 in einer Draufsicht. Der Radiator 16 befindet sich auf einer langen Seitenwand des Trafo 1. Die Verbindung mit dem Energieversorgungsnetz erfolgt über Hochspannungs-Durchführungen und Dome 10 die auf dem Dach des Kessels 2 angeordnet sind. Auf dem Deckel des Kessels 2 befindet sich auch ein Dehngefäß 15. Das Dehngefäß 15 hat die Form eines Zylinders. Die Mantelfläche des Dehngefäßes 15 liegt etwa parallel zur Ebene des Kesseldeckels. Eine Stirnseite des Zylinders springt seitlich vom Grundriss des Transformatorkessels vor. Wie in der Zeichnung der Figur 3 dargestellt ist nicht nur der Kessel 2, sondern auch die Oberfläche des Dehngefäß 17, d.h. dessen Mantelfläche und Stirnseiten, von einer Panzerung 4 abgedeckt. Diese Panzerung 4 kann ebenfalls aus einzelnen Paneelen 7 zusammengesetzt sein. Die Paneele 7 sind hier vertikal und horizontal angeordnet.

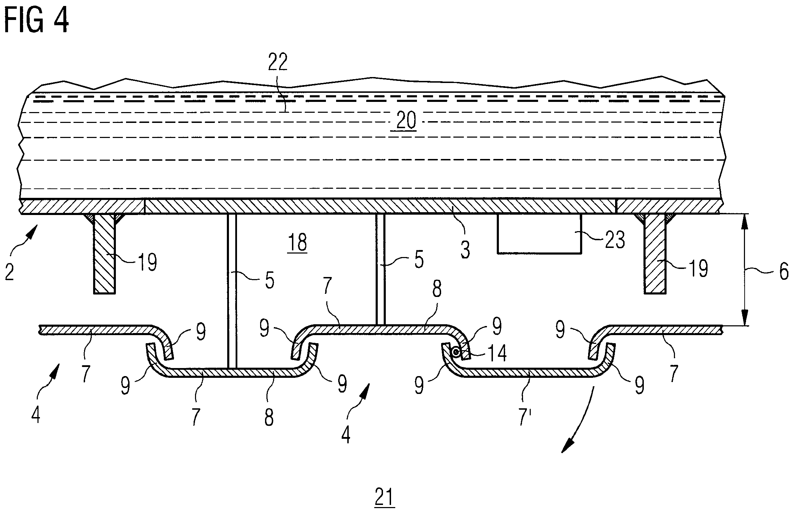

Figur 4 zeigt ein Detail X der Figur 3 in einer vergrößerten Darstellung. Gezeichnet ist beispielhaft eine bevorzugte Profilierung und Anordnung der einzelnen Paneele 7. Die Paneele 7 sind nebeneinanderliegend vertikal angeordnet. Die Paneele 7 überlappen einander seitlich. Jedes Paneel 7 ist mittels mehrerer Befestigungselemente 5 mit dem Kessel 2 bzw. einer Seitenwand 3 des Kessels 2 verbunden. Die Befestigung kann entweder direkt an der Kesselwand 3 verankert sein, oder an Rippen oder Verstärkungen 19 des Kessels 2. Die einzelnen Paneele 7 der Armierung 4 sind in einem Abstand 6 rings umlaufend zur Kesselwand 3 angeordnet. Die Befestigungselemente 5, die im Folgenden noch näher beschriebenen werden, befinden sich in einem umlaufenden Zwischenraum 18, der durch die Kesselwand 3 und die gegenüberliegende Innenseite der Paneele 9 begrenzt wird. Wie in Figur 4 dargestellt, haben die Paneele 7 in einer bevorzugten Ausführung die Form eines U-Profils, bestehend aus zwei Schenkelteilen 9 und einem Verbindungsteil 8. Die Schenkelteile 9 sind bezüglich dem sie verbindenden Verbindungsteil 8 hochgebogen und schließen mit diesem Verbindungsteil 8 jeweils einen stumpfen Winkel ein. Die Anordnung ist dabei so gewählt, dass benachbart zueinander liegende Paneele 7 bezüglich ihres Querschnitts spiegelbildlich zueinander liegen. In dieser Anordnung untergreifen Schenkelteile 9 einander. Dabei ist ein Spalt gelassen. Der Spalt und die Form der Biegung der Schenkel 9 sind so bemessen, dass quasi ein Labyrinth gebildet wird. Dieses Labyrinth wehrt im Bereich der Stoßstelle ein Eindringen eines aus dem Außenraum 21 abgeschossenen Beschuss- oder Splitterkörpers ab. Trifft ein Splitter oder eine Kugel auf eines der Paneele 7, so ist durch die Anbringung der Befestigungselemente 5 sichergestellt, dass sich die Energie des Geschosses auf mehrere Befestigungspunkte aufteilt. Jedes Paneel 7 ist durch mehrere Stützstellen am Kessel 2 abgestützt. Damit ist die Druckwelle, die sich in der Kühl- und Isolationsflüssigkeit 22 im Kesselinnenraum 20 ausbreitet in ihrer Intensität geringer. Dadurch kann vermieden werden, dass es im Falle der Einwirkung eines Beschlusses oder einer äußeren Explosionseinwirkung zu einem unbeabsichtigten Abschalten der Anlage kommt. Die Versorgung mit elektrischer Energie in einem Verteilungsnetz wird im Falle eines zerstörerischen Angriffes aufrechterhalten. Sofern es zu einer starken Beschädigung von Paneelen kommt können diese auf einfache Weise gewechselt werden.

In der Darstellung der Figur 4 ist auch ein Scharnier 14 zu sehen, wodurch das Paneele 7' gemäß dem Pfeil vom Transformator-Kessel 2 weg geschwenkt werden kann. Durch diese Schwenkmöglichkeit eines oder mehrere der Paneele 7' ist es möglich, dass Betriebsmittel oder Anbauteile 23, die sich im Zwischenraum 18 zwischen Armierung 4 und Kesselwand 3 befinden, von außen zugänglich sind. Ein solches Betriebsmittel 23 kann eine Anzeige-, Schalt-, oder Verbindungseinrichtung sein.

Ein Paneel 7 kann eine Breite von 20 cm bis in den Bereich von Metern aufweisen. Das Scharnier 17 kann sich über die gesamte Höhe oder nur über einen Höhenabschnitt erstrecken.

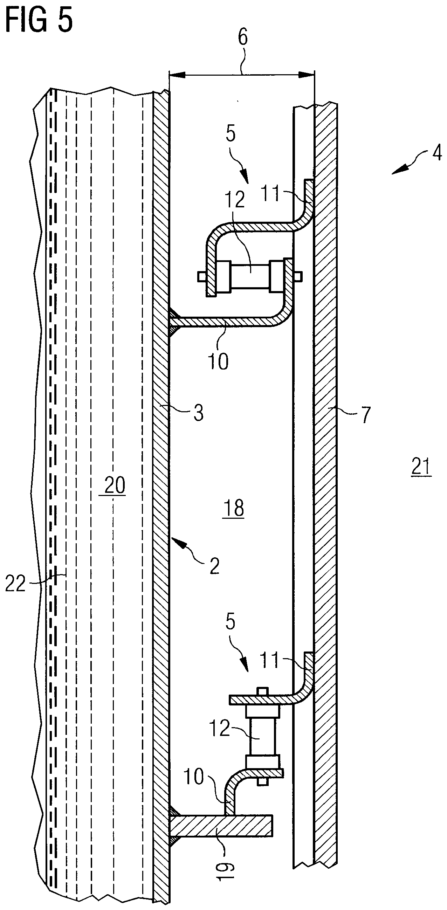

Die Figur 5 zeigt eine mögliche Ausbildung der Befestigungsvorrichtung 5 der Paneele 7 am Kessel 2. Die Paneele 7 sind in einem Abstand 6 bezüglich der Kesselwand 3 vertikal befestigt. Zwischen der Kesselwand 2 und einem Paneel 7 ist ein Zwischenraum 18. In Figur 5 ist beispielhaft eine Befestigung mit zwei Befestigungselementen 5 dargestellt. Das obere und das untere Befestigungselement 5 besteht dabei im Wesentlichen aus einem Metall-Gummi-Metall-Bauteil, der mittels einer kesselseitigen Konsole 10 und einer paneelseitigen Konsole 11 jeweils an der Kesselwand 2 bzw. am Paneel 7 befestigt ist. In der dargestellten beispielhaften Ausführung ist der obere Befestigungskörper 5 horizontal, der untere Befestigungskörper 5 vertikal angeordnet. Dies erleichtert die Montage, indem das Paneel 7 unten eingehängt und anschließend oben beispielsweise durch eine Schraubverbindung befestigt wird. Das Paneel 7 ist dadurch schwingungstechnische vom Kessel 2 entkoppelt. Anstelle von Gummi kann auch ein Federstahl zur Entkoppelung und Befestigung verwendet werden.

Um Betriebsgeräusche zu minder, bietet es sich an, den in Figur 4 und 5 gezeichnete ringförmige Zwischenraum 18 mit einem geräuschdämmenden Material zu füllen.

Obwohl die Erfindung im Detail durch bevorzugte Ausführungsbeispiele näher illustriert und beschrieben wurde, so ist die Erfindung nicht durch die offenbarten Beispiele eingeschränkt. Andere Variationen können vom Fachmann hieraus abgeleitet werden, ohne den Schutzumfang der Erfindung zu verlassen.

So kann es je nach Größe eines Leistungstransformators oder einer Drossel vorteilhaft sein, jedes Paneel 7 mit mehreren Befestigungspunkten am Kessel 2 zu befestigen. Selbstverständlich können zur Befestigung die am Kessel 2 bereits vorhandenen Verstärkungen bzw. Rippen benutzt bzw. mitbenutzt werden. Geeignete Befestigungsmöglichkeiten können bevorzugt bei der Herstellung des Kessels bereits durch Schweißverbindung vorgesehen sein. Im dargestellten Ausführungsbeispiel besteht ein Paneel 7 aus einem einzigen Stahlblech mit einer hohen Zugfestigkeit. Um Beschuss- oder Explosiveinwirkung vom Kessel fernzuhalten können aber auch nichtmetallische Werkstoffe eingesetzt werden. Es ist denkbar, dass die Paneele 7 Sandwichpaneele sind, oder aus einem Kunststoff-Metallverbundwerkstoff hergestellt sind. Es ist auch denkbar, dass für die Panzerung 7 ausschließlich ein Polymerwerkstoff verwendet wird, zum Beispiel aus einzelnen aus Kunststoff-Paneelen 7 besteht. Die Panzerung 4 wird dadurch leichtgewichtig, aber auch teurer. Beispielsweise die Kunststoff-Paneele 7 aus der Aramidfaser Kevlar^{®}, oder einem High Performance Polyethylen (HPDE) oder einem anderen geeigneten Polymer hergestellt sind.

Die Erfindung ist nicht auf den oben beschriebenen Leistungstransformator beschränkt, sondern allgemein auf elektrische Anlagen in Energieversorgungsnetzen anwendbar, zum Beispiel mit Schutzgas betriebene Hochspannungsschalter oder ähnlichen Anlagen.

### Zusammenstellung der verwendeten Bezugszeichen

- 1: Transformator
- 2: Kessel
- 3: Seitenwand
- 4: Armierung, Panzerung
- 5: Befestigungselement
- 6: Abstand
- 7,7': Paneel
- 8: Verbindungsteil U-Profil
- 9: Schenkel
- 10: Konsole zum Kessel
- 11: Konsole zum Paneel
- 12: Federelement
- 13: Dom
- 14: Scharnier
- 15: Dehngefäß
- 16: Kühlradiator
- 17: Kühleröffnung
- 18: Zwischenraum
- 19: Versteifung an Kesselwand außen
- 20: Innenraum des Kessels
- 21: Außenraum
- 22: Kühl- und Isolationsflüssigkeit
- 23: Betriebsmittel, Anbauteile

## Patentansprüche

1. Elektrische Anlage, insbesondere Transformator, Phasenschieber oder Drossel, mit einem fluidgefüllten Kessel (2), der Seitenwände (3) aufweist, **dadurch gekennzeichnet, dass** zum Schutz vor Beschuss- und/oder Splittereinwirkung
- die Seitenwände (3) durchschusshemmend aus einem Werkstoff, der eine Zugefestigkeit Rₘ aufweist, die größer als 1000 MPa ist, gebildet sind.

## Claims

1. Electrical installation, in particular a transformer, phase shifter or inductor, comprising a fluid-filled tank (2) having side walls (3), **characterised in that**, for protection against the effect of bullets and/or fragments,
- the side walls are so formed as to be penetrationinhibiting and made of a material having a tensile strength Rₘ greater than 1000 MPa.

## Revendications

1. Installation électrique, notamment transformateur, déphaseur ou bobine de self, comprenant une cuve (2) emplie de fluide, qui a des parois (3) latérales **caractérisée en ce que**, pour se protéger de l'effet de bombardement et/ou d'éclats,
- les parois (3) latérales sont, pour s'opposer au jaillissement, en un matériau, qui a une résistance Rₘ à la traction plus grande que 1000 MPa.
